# EUROPEAN PATENT APPLICATION

(11) **EP 4 796 894 A1**
(43) Date of publication of application: **26.08.2026**
(21) Application number: 25197947.2
(22) Date of filing: 25.08.2025
(51) Int. Cl.: G01B 9/02, G03F 7/00

(54) **A POSITION MEASUREMENT SYSTEM TO MEASURE A POSITION ALONG AN OPTICAL PATH**

(71) Applicant: ASML Netherlands B.V., 5500 AH Veldhoven (NL)
(72) Inventor: YUCE, Emre, 5500 AH Veldhoven (NL); JANSEN, Maarten, Jozef, 5500 AH Veldhoven (NL)
(74) Representative: ASML Netherlands B.V.

(57) **Abstract**

A position measurement system is disclosed, comprising an interferometer system, a multimode optical fiber, and a processing unit. The interferometer system is configured to measure a position along an optical path, to output a position measurement signal representative of the position into the multimode optical fiber, which produces at its output a spatial intensity profile. One or more detectors detect the spatial intensity profile, each detector comprising a plurality of pixels, each pixel corresponding to a distinct spatial region of the spatial intensity profile. The processing unit analyses each distinct spatial region and performs a mathematical analysis between a plurality of distinct spatial regions to determine one or more properties related to mode dispersion of the position measurement signal. Based on the determined properties, the processing unit identifies disturbances and/or errors in the position measurement signal.

## Description

### FIELD

The present invention relates to a position measurement system, an exposure appartus comprising a position measurement system, a projection system for an exposure appartus comprising a position measurement system and a method for measuring a position along an optical path.

### BACKGROUND

An exposure apparatus, such as a lithographic apparatus, is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

In such lithographic apparatus, precise positioning of one or more stages relative to an optical projection system is required. Interferometry systems are commonly employed to provide accurate position measurements of the stage.

In some implementations, a multimode optical fiber is used to guide an optical signal from an interferometer system to a detector. The detector may be arranged to generate a position measurement signal based on the received optical signal.

The detector may comprise a single photodiode arranged to detect an intensity of the optical signal output from the multimode fiber. Such an arrangement results in the spatial intensity distribution of the multimode fiber output being integrated into a single value. While this integrated intensity can be used for position measurement, it omits spatial information relating to the distribution of individual modes within the multimode fiber output.

Information carried in these individual modes can include, for example, disturbances or polarization leakage effects, such as those arising from optical components in the interferometer system. Since such effects may contribute to measurement errors, their identification can enable more accurate compensation in the position measurement. However, in known systems employing a single photodiode, this information is lost, thereby limiting the ability to correct for such effects in real time.

### SUMMARY

Therefore, according to an aspect of the invention there is provided a position measurement system comprising an interferometer system, a multimode optical fiber and a processing unit,
the interferometer system being configured to measure a position along an optical path to obtain a position measurement and to output a position measurement signal representative of the position measurement into the multimode optical fiber,
the multimode optical fiber being configured to output at a multimode optical fiber output a spatial intensity profile,
the interferometer system comprising one or more detectors configured to detect the spatial intensity profile at the multimode optical fiber output,
the one or more detectors comprising a plurality of pixels, each pixel is configured to detect a distinct spatial region of the spatial intensity profile,
the processing unit being configured to:
   analyse each distinct spatial region, and
   perform a mathematical analysis between a plurality of distinct spatial regions to determine one or more properties related to mode dispersion of the position measurement signal, and
   identify disturbances and/or errors in the position measurement signal based on the one or more properties determined with the mathematical analysis.

In an embodiment, the processing unit is further configured to correct the position measurement signal based on the identified disturbances and/or errors.

In an embodiment, the spatial intensity profile comprises a speckle pattern resulting from interference between different spatial modes in the multimode optical fiber.

In an embodiment, the processing unit is further configured to apply a mathematical model or a machine learning model configured to identify the disturbances and/or errors in the spatial intensity profile.

In an embodiment, the identified disturbances and/or errors include at least one of: mechanical vibrations, thermal variations, modal noise, polarization variations or wavefront misalignments along the optical path.

In an embodiment, a lens system is arranged between the multimode optical fiber output and the one or more detectors.

In an embodiment, the interferometer system comprises a heterodyne interferometer.

In an embodiment, the plurality of pixels comprises at least two pixels and up to at least three times the number of speckles of the spatial intensity profile.

In an embodiment, the plurality of pixels is arranged in a linear or two-dimensional detector array.

In an embodiment, the processing unit is configured to initiate the mathematical analysis from a central pixel located at or near the center of the detector array, and to perform the mathematical analysis with one or more pixels located radially outward from the central pixel.

In an embodiment, the one or more detectors comprise a CMOS or CCD sensor.

In an embodiment, the mathematical analysis is selected from differential analysis, integral analysis, moment analysis, Fourier analysis, or combinations thereof.

According to an aspect of the invention, there is provided an exposure apparatus comprising a position measurement system according to the invention.

According to an aspect of the invention, there is provided an projection system for an exposure apparatus, comprising a position measurement system according to the invention.

According to an aspect of the invention, there is provided a method for measuring a position along an optical path, the method comprising the steps of:
measuring the position along the optical path to obtain a position measurement,
outputting a position measurement signal representative of the position measurement,
providing the position measurement signal to a multimode optical fiber,
outputting by the multimode optical fiber a spatial intensity profile based on the position measurement signal,
detecting the spatial intensity profile by one or more detectors comprising a plurality of pixels, each pixel being configured to detect a distinct spatial region of the spatial intensity profile,
analysing each distinct spatial region by performing a mathematical analysis between a plurality of distinct spatial regions to determine one or more properties related to mode dispersion of the position measurement signal, and
identifying disturbances and/or errors in the position measurement signal based on the one or more properties determined with the mathematical analysis.

In an embodiment, the method further comprises the step of correcting the position measurement signal based on the identified disturbances and/or errors.

Further features of the disclosure, as well as the structure and operation of various embodiments of the disclosure, are described in detail below with reference to the accompanying drawings. It is noted that the disclosure is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

The accompanying drawings, which are incorporated herein and form part of the specification, illustrate the present disclosure and, together with the description, further serve to explain the principles of the disclosure and to enable a person skilled in the relevant art(s) to make and use the disclosure. Embodiments of the present disclosure will now be described, by way of example only, with reference to the accompanying schematic drawings, in which:
Figure 1 depicts a lithographic system comprising a lithographic apparatus and a radiation source;
Figure 2 schematically depicts an embodiment of a position measurement system according to the invention;
Figure 3 schematically depicts an embodiment of a pixelated detector which may be comprised in the position measurement system of Figure 2;
Figure 4 schematically depicts examples of speckle patterns detected using pixelated detectors having 4, 6, and 9 pixels, respectively.

The features of the present disclosure will become more apparent from the detailed description set forth below when taken in conjunction with the drawings, in which like reference characters identify corresponding elements throughout. In the drawings, like reference numbers generally indicate identical, functionally similar, and/or structurally similar elements. Additionally, generally, the left-most digit(s) of a reference number identifies the drawing in which the reference number first appears. Unless otherwise indicated, the drawings provided throughout the disclosure should not be interpreted as to-scale drawings.

### DETAILED DESCRIPTION

The invention will be explained in more detail below with reference to drawings in which illustrative embodiments thereof are shown. The drawings are intended exclusively for illustrative purposes and not as a restriction of the inventive concept which is to cover all modifications, equivalents, and alternatives falling within the scope of the present invention. The scope of the invention is only limited by the definitions presented in the appended claims.

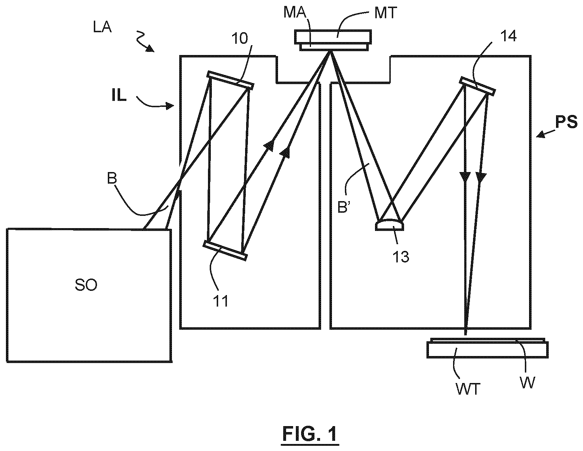

Fig. 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Fig. 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning device MA may be a mask or reticle, which imparts a pattern to a radiation beam transmitted or reflected by the patterning device. Well-known modes of operation include a stepping mode and a scanning mode. As is well known, the projection system PS may cooperate with support and positioning systems for the substrate W and the patterning device MA in a variety of ways to apply a desired pattern to many target portions across the substrate W. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The depicted apparatus could be used in a variety of modes. In a scan mode, the patterning device support (e.g., mask table) MT and the substrate table WT are scanned synchronously while a pattern imparted to the radiation beam is projected onto a target portion (i.e., a single dynamic exposure). A direction in which the patterning device MA is scanned is called a scanning direction. The speed and direction of the substrate table WT relative to the patterning device support (e.g., mask table) MT may be determined by the (de-)magnification and image reversal characteristics of the projection system PS. In the scan mode, a maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In step mode, the patterning device support MT and the substrate table WT are kept essentially stationary, while an entire pattern imparted to the radiation beam B is projected onto a target portion at one time (i.e., a single static exposure). The substrate table WT is then shifted in a X and/or Y direction so that a different target portion may be exposed.

Combinations and/or variations on the above described modes of use or entirely different modes of use may also be employed. For example, in a step-and-scan mode an area that receives light at any point in time is smaller than the full field. This area is called a slit as described below. During the exposure process, both the substrate W and the patterning device MA are moved (at a substantially constant speed). The patterning device MA is scanned such that each portion of the pattern, corresponding to a size of the slit, gets sequentially illuminated. The reflected radiation from the patterning device MA is directed to the substrate W which is moved in synchronism to project the illuminated portion of the pattern at a correct location on the substrate W.

The largest area which can be exposed in a single exposure of a lithographic apparatus is defined by its scanning field area. The illumination system IL may comprise an illumination slit which determines the scanning field area, i.e. an illuminated area of the patterning device MA per a single scan. This is defined by a width of the illumination slit in the scanning direction (often designated as an X-direction) and the maximum scan length in the orthogonal direction (the non-scanning direction, often designated as a Y-direction) of the same plane (in short, the orthogonal direction Y). In some cases, the die area (the substrate area of the device being manufactured, referred to herein as the substrate field area or substrate region area) is larger than the maximum scanning field area. In this situation, some or all layers of the device need to be exposed on the substrate region (or substrate field) in multiple (e.g., two) separate adjacent exposures. For example: a substrate region twice as large as the maximum scanning field area may be exposed in two exposures: a first exposure using a first reticle comprising a first pattern is used to print a first substrate sub-region (e.g., first half in terms of area on the substrate) of the layer, and a second reticle comprising a second pattern is used to print a second sub-region of the layer (e.g., the second half) on the substrate, adjacent the first half therefore forming the complete layer. The two halves can be referred to as having been "stitched" together, with the process sometimes referred to as intra-die stitching.

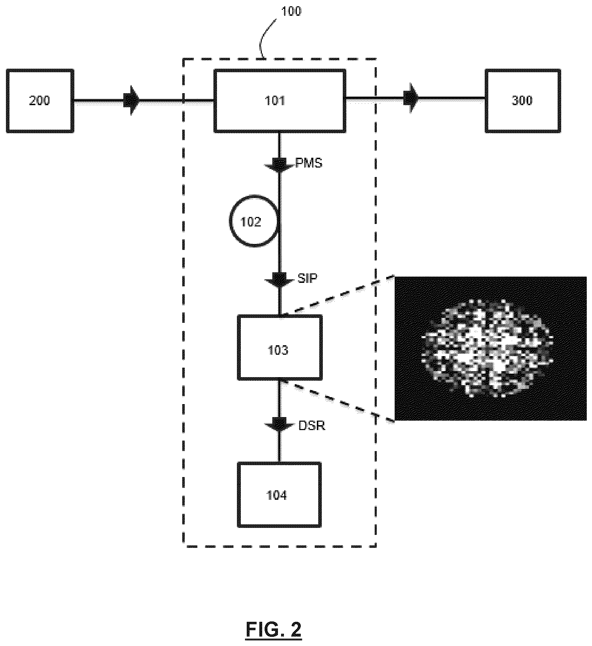

Figure 2 schematically depicts an embodiment of a position measurement system 100 according to the invention. The position measurement system 100 may be part of an exposure apparatus or projection system, for example for lithography applications, to provide accurate measurements of the position of one or more optical components along the optical path. The position measurement system 100 is configured to measure the position of a moving object 300, which may for example be a wafer stage, a reticle stage, or a reflective optical element such as a mirror. In operation, the position of the moving object 300 may vary in one or more degrees of freedom, and the position measurement system 100 is configured to track such position variations.

The position measurement system 100 comprises an interferometer system 101, which is optically coupled to a radiation source 200. The interferometer system 101 may, for example, comprise a heterodyne interferometer. Alternatively, the interferometer system 101 may include a homodyne interferometer, a PGC interferometer, a multiwavelength interferometer, or a sweep-source interferometer. The radiation source 200 may comprise a coherent source such as a laser, optionally stabilized in wavelength, polarization, and intensity to improve metrological stability. The interferometer system 101 directs a radiation beam from the radiation source 200 along an optical path toward the moving object 300 and receives a reflected radiation beam therefrom. Within the interferometer system 101, the reflected radiation beam is recombined with a reference radiation beam to generate a position measurement signal PMS. The position measurement signal PMS encodes the displacement of the moving object 300 as a phase variation of the interference fringes, in accordance with interferometric measurement principles.

In the shown embodiment, the position measurement signal PMS is transmitted from the interferometer system 101 to a multimode optical fiber 102. The multimode optical fiber 102 supports the propagation of a plurality of optical modes, each having a distinct spatial field distribution and optionally a distinct polarization state. Disturbances in the position measurement system 100, for example, mechanical vibrations, thermal variations, or imperfections in the interferometer system 101, can alter the relative phase, amplitude, or polarization of these modes. Consequently, the set of modes arriving at the output end of the multimode optical fiber 102 contains embedded information about such disturbances.

When these different spatial modes interfere upon exiting the multimode optical fiber 102, they form a spatial intensity profile SIP. In practice, the spatial intensity profile SIP comprises a speckle pattern. The speckle pattern comprises a plurality of speckle features, also referred to as speckles, corresponding to bright and dark regions in the spatial intensity profile resulting from modal interference. Hereafter, the spatial intensity profile SIP may also be referred to as the speckle pattern.. The speckle pattern is the result of multiple interference between the different spatial modes, each having experienced slightly different optical path lengths and phase shifts during propagation. Although the speckle pattern appears random, it is in fact a deterministic and structured optical fingerprint of the input conditions and the environment experienced by the radiation beam along its optical path. The spatial intensity profile SIP contains physical information about, for example, the original position measurement signal PMS, the coupling conditions into the multimode optical fiber 102 such as wavefront tilt and polarization state, and external disturbances affecting the multimode optical fiber 102 and optics, such as mechanical vibrations or thermal variations. Because each spatial mode propagates with a different velocity and experiences different phase accumulation, changes in the radiation beam, the multimode optical fiber 102 geometry, or the environment will cause measurable changes in the spatial intensity profile SIP. These changes may occur in the form of speckle grain shifts, intensity redistributions, polarization-dependent modulations, or variations in fringe contrast.

At the output of the multimode optical fiber 102, the spatial intensity profile SIP is projected onto a detector 103. Unlike conventional single-element detectors, which integrate the optical intensity over the entire output of the multimode optical fiber 102 and thereby lose spatial discrimination, the detector 103 is configured to spatially resolve the spatial intensity profile SIP. In Figure 2, the detector 103 is a pixelated array with each pixel arranged to detect radiation from a distinct spatial region DSR of the spatial intensity profile SIP. The detector 103 may be of any sensor type suitable for measuring optical intensity. Non-limiting examples include CMOS sensors, CCD sensors, avalanche photodiodes, photodiodes, photomultiplier tubes, phototransistors, photoresistors, thermopiles, bolometers, and thermocouples. The resolution may be chosen such that each distinct spatial region DSR covers an area comparable to the spatial scale of the speckle features in the spatial intensity profile SIP, thereby allowing individual mode interference patterns to be distinguished.

The detector 103 is operatively coupled to a processing unit 104. The processing unit 104 is configured to analyse each distinct spatial region DSR. The processing unit 104 is configured to perform a mathematical analysis between a plurality of distinct spatial regions DSR to determine one or more properties related to mode dispersion of the position measurement signal PMS. The mathematical analysis may be selected from differential analysis, integral analysis, moment analysis, Fourier analysis, or combinations thereof. Mode dispersion refers to the fact that the radiation beam propagating through a multimode optical fiber 102 does so in multiple distinct spatial modes, each with a different propagation constant and therefore a different group velocity. This means that when the position measurement signal PMS travels through the multimode optical fiber 102, each mode will accumulate a slightly different phase shift or arrive at the detector 103 at a slightly different time. These differences lead to measurable effects in the spatial intensity profile SIP, such as relative phase shifts between modes, amplitude modulation, or polarization-dependent mode behaviour. By mathematically analysing multiple distinct spatial regions DSR, the processing unit 104 can identify disturbances and/or errors in the position measurement signal PMS based on one or more properties related to mode dispersion. As used herein, the disturbances and/or errors refer to any environmental or system-induced variations that affect the propagation of the position measurement signal PMS, including but not limited to mechanical vibrations, thermal variations, modal noise, polarization variations or wavefront misalignments along the optical path.

For example, the processing unit 104 may detect that certain distinct spatial regions DSR respond earlier, more strongly, or with different modulation compared to others. The processing unit 104 may correct the position measurement signal PMS based on the identified disturbances and/or errors. For example, the modal properties can be used to derive correction signals that compensate for the disturbances and/or errors, thereby improving the accuracy of the position measurement signal PMS.

The processing unit 104 may be configured to apply a mathematical model or a machine learning model configured to identify the disturbances and/or errors in the spatial intensity profile SIP. For example, the processing unit 104 may input measured intensity values from each distinct spatial region DSR into a machine learning model, which is trained to recognize patterns indicative of disturbances caused by environmental or system-induced effects. The machine learning model may include, for example, regression-based algorithms, neural networks, or support vector machines. The machine learning model can output one or more disturbance metrics, error estimates, or correction parameters, which can then be used to compensate for or correct the identified disturbances and/or errors in the position measurement signal PMS. The machine learning model may further be continuously updated or adapted based on ongoing position measurements, allowing the processing unit 104 to dynamically adjust for changing conditions such as mechanical vibrations, thermal variations, modal noise, polarization variations or wavefront misalignments along the optical path..

In an embodiment, the processing unit 104 performs a differential analysis between the plurality of distinct spatial regions DSR. In one example, the differential analysis comprises calculating the difference between the optical intensity values of two or more distinct spatial regions DSR, so as to suppress common-mode noise present across the spatial intensity profile SIP while retaining variations arising from modal interference. In another example, the differential analysis comprises computing a ratio between intensity values of different distinct spatial regions DSR, thereby normalizing for overall intensity fluctuations due to radiation source power drift.

The processing unit 104 may further be configured to perform a spatial correlation analysis between the temporal evolution of intensity patterns in different distinct spatial regions DSR, so as to detect mode-specific disturbances such as phase fluctuations induced by vibration or thermal expansion of the multimode optical fiber 102. In another example, the processing unit 104 may perform a Fourier analysis of the temporal intensity variations of each distinct spatial region DSR to separate low-frequency drift effects from high-frequency vibration signatures.

Additionally or alternatively, the processing unit 104 may be configured to extract polarization-dependent features by comparing the relative intensity changes between distinct spatial regions DSR that are sensitive to orthogonal polarization components. By comparing and processing the signals from multiple distinct spatial regions DSR in this manner, the processing unit 104 determines one or more modal properties of the position measurement signal PMS.

Once the one or more modal properties are determined, the processing unit 104 can identify the presence and magnitude of disturbances and/or errors affecting the position measurement signal PMS. These identified disturbances and/or errors may then be fed into a real-time correction algorithm, which compensates the position measurement signal PMS accordingly before it is used for position determination. The correction may involve phase unwrapping, disturbance-model subtraction, or adaptive filtering based on the detected modal behaviour.

By exploiting the mode-specific information contained in the spatial intensity profile SIP, the position measurement system 100 achieves improved accuracy and robustness.

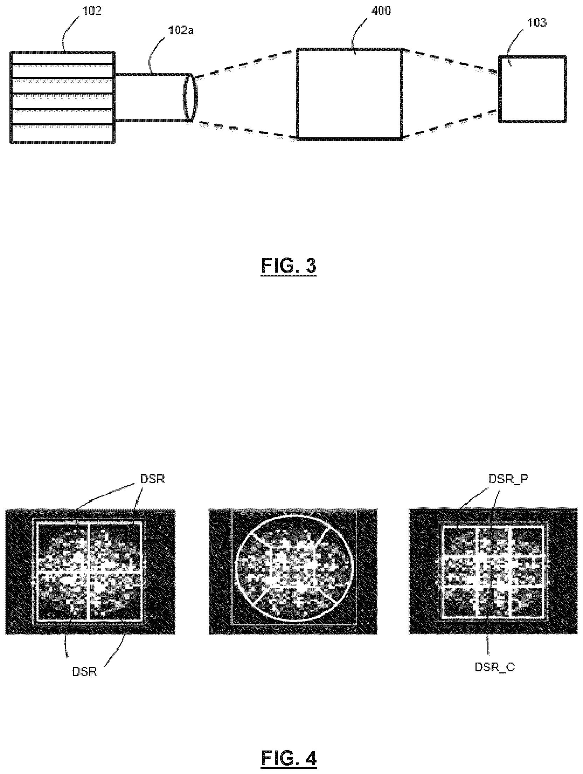

Figure 3 schematically depicts an embodiment of a pixelated detector 103 which may be comprised in the position measurement system 100 of Figure 2. The position measurement signal PMS is transmitted via the multimode optical fiber 102 and exits through the multimode optical fiber output 102a. At the multimode optical fiber output 102a, the PMS typically exhibits a spatial intensity profile SIP.

An optical system 400, such as a lens system, is arranged between the multimode optical fiber output 102a and the pixelated detector 103. The optical system 400 is configured to image or project the spatial intensity profile SIP onto an active surface of the detector 103, such that the speckle pattern is resolved across a plurality of detector pixels. The optical configuration of the optical system 400, including focal length, numerical aperture NA, and alignment, is selected in accordance with the wavelength of the position measurement signal PMS, the numerical aperture NA of the multimode fiber 102, and the mode field diameter at the multimode optical fiber output 102a. By tailoring these parameters, the diverging output beam from the multimode optical fiber is effectively captured and focused, ensuring that the complete speckle pattern is contained within the detector's active surface area without significant clipping or loss of spatial resolution.

In some embodiments, the optical system 400 may be omitted, and the multimode optical fiber output 102a may be positioned at a predetermined free-space distance from the surface of the detector 103. This distance is selected such that the divergence of the output beam is contained within the detector's active area, while preserving sufficient spatial resolution for resolving the distinct spatial regions DSRs of the speckle pattern. The minimum possible distance between the multimode optical fiber output 102a and the detector 103 can even be zero, in which case the fiber output is placed directly against or in close proximity to the detector surface. In such a configuration, the beam diameter on the detector is determined by the NA of the multimode optical fiber and the wavelength, and the arrangement ensures that the detector captures the full modal interference pattern without intermediate imaging optics.

Figure 4 schematically depicts non-limiting examples of spatial intensity profiles SIP in the form of speckle patterns detected using pixelated detectors configured with different pixel arrangements. In the illustrated examples, the speckle pattern is divided into four pixels (left image), six pixels (middle image), and nine pixels (right image), each pixel representing a distinct spatial region DSR from which an individual measurement signal is obtained. The boundaries of each distinct spatial region DSR are indicated schematically by straight or curved lines, which in practice may correspond to physical detector pixel boundaries, grouped detector elements, or computationally defined regions resulting from digital post-processing.

In the example of the nine-pixel detector array (right image), the distinct spatial regions DSRs include a central pixel DSR_C located at or near the center of the array, surrounded by peripheral pixels DSR_P positioned radially outward. In some embodiments, the processing unit 104 is configured to initiate the mathematical analysis from such a central DSR_C and to perform a differential analysis with one or more peripheral pixels DSR_P, for example to evaluate spatial correlation patterns and to determine properties related to mode dispersion. However, the invention is not limited to this specific arrangement or analysis order; the differential analysis may be performed between any combination of DSRs, in any sequence, and using an alternative mathematical analysis such as intensity subtraction, ratio computation, cross-correlation, or frequency-domain decomposition.

The different pixel configurations shown in Figure 4 illustrate that the number, size, and geometry of the DSRs can be freely selected based on application-specific requirements, such as detector resolution, desired spatial sampling density, signal-to-noise optimization, or computational complexity constraints. For instance, a smaller number of larger DSRs may be advantageous for highspeed analysis with reduced data volume, whereas a larger number of smaller DSRs can enable finer spatial discrimination of modal interference effects. In all cases, the processing unit 104 may process the detected intensity values from the DSRs to extract modal properties of the PMS, to suppress common-mode noise, and/or to identify and correct for disturbances and/or errors in the position measurement system 100.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below. Other aspects of the invention are set out as in the following numbered clauses:
1. A position measurement system comprising an interferometer system, a multimode optical fiber and a processing unit,
   the interferometer system being configured to measure a position along an optical path to obtain a position measurement and to output a position measurement signal representative of the position measurement into the multimode optical fiber,
   the multimode optical fiber being configured to output at a multimode optical fiber output a spatial intensity profile,
   the interferometer system comprising one or more detectors configured to detect the spatial intensity profile at the multimode optical fiber output,
   the one or more detectors comprising a plurality of pixels, each pixel is configured to detect a distinct spatial region of the spatial intensity profile,
   the processing unit being configured to:
      - analyse each distinct spatial region, and
      - perform a mathematical analysis between a plurality of distinct spatial regions to determine one or more properties related to mode dispersion of the position measurement signal, and
      - identify disturbances and/or errors in the position measurement signal based on the one or more properties determined with the mathematical analysis.
2. The position measurement system of clause 1, wherein the processing unit is further configured to correct the position measurement signal based on the identified disturbances and/or errors.
3. The position measurement system of clause 1 or clause 2, wherein the spatial intensity profile comprises a speckle pattern resulting from interference between different spatial modes in the multimode optical fiber.
4. The position measurement system of any of the preceding clauses, wherein the processing unit is further configured to apply a mathematical model or a machine learning model configured to identify the disturbances and/or errors in the spatial intensity profile.
5. The position measurement system of any of the preceding clauses, wherein the identified disturbances and/or errors include at least one of: mechanical vibrations, thermal variations, modal noise, polarization variations or wavefront misalignments along the optical path.
6. The position measurement system of any of the preceding clauses, wherein a lens system is arranged between the multimode optical fiber output and the one or more detectors.
7. The position measurement system of any of the preceding clauses, wherein the interferometer system comprises a heterodyne interferometer.
8. The position measurement system of any of the preceding clauses, wherein the plurality of pixels comprises at least two pixels and up to at least three times the number of speckles of the spatial intensity profile.
9. The position measurement system of any of the preceding clauses, wherein the plurality of pixels is arranged in a linear or two-dimensional detector array.
10. The position measurement system of clause 9, wherein the processing unit is configured to initiate the mathematical analysis from a central pixel located at or near the center of the detector array, and to perform the mathematical analysis with one or more pixels located radially outward from the central pixel.
11. The position measurement system of any of the preceding clauses, wherein the one or more detectors comprise a CMOS or CCD sensor.
12. The position measurement system of any of the preceding clauses, wherein the mathematical analysis is selected from differential analysis, integral analysis, moment analysis, Fourier analysis, or combinations thereof.
13. An exposure apparatus comprising a position measurement system according to any of the preceding clauses 1-12.
14. A projection system for an exposure apparatus, comprising a position measurement system according to any of the preceding clauses 1-12.
15. A method for measuring a position along an optical path, the method comprising the steps of:
   - measuring the position along the optical path to obtain a position measurement,
   - outputting a position measurement signal representative of the position measurement,
   - providing the position measurement signal to a multimode optical fiber,
   - outputting by the multimode optical fiber a spatial intensity profile based on the position measurement signal,
   - detecting the spatial intensity profile by one or more detectors comprising a plurality of pixels, each pixel being configured to detect a distinct spatial region of the spatial intensity profile,
   - analysing each distinct spatial region by performing a mathematical analysis between a plurality of distinct spatial regions to determine one or more properties related to mode dispersion of the position measurement signal, and
   - identifying disturbances and/or errors in the position measurement signal based on the one or more properties determined with the mathematical analysis.
16. The method of clause 15, further comprising the step of correcting the position measurement signal based on the identified disturbances and/or errors.

## Claims

1. A position measurement system comprising an interferometer system, a multimode optical fiber and a processing unit,
the interferometer system being configured to measure a position along an optical path to obtain a position measurement and to output a position measurement signal representative of the position measurement into the multimode optical fiber,
the multimode optical fiber being configured to output at a multimode optical fiber output a spatial intensity profile,
the interferometer system comprising one or more detectors configured to detect the spatial intensity profile at the multimode optical fiber output,
the one or more detectors comprising a plurality of pixels, each pixel is configured to detect a distinct spatial region of the spatial intensity profile,
the processing unit being configured to:
- analyse each distinct spatial region, and
- perform a mathematical analysis between a plurality of distinct spatial regions to determine one or more properties related to mode dispersion of the position measurement signal, and
- identify disturbances and/or errors in the position measurement signal based on the one or more properties determined with the mathematical analysis.

2. The position measurement system of claim 1, wherein the processing unit is further configured to correct the position measurement signal based on the identified disturbances and/or errors.

3. The position measurement system of claim 1 or claim 2, wherein the spatial intensity profile comprises a speckle pattern resulting from interference between different spatial modes in the multimode optical fiber.

4. The position measurement system of any of the preceding claims, wherein the processing unit is further configured to apply a mathematical model or a machine learning model configured to identify the disturbances and/or errors in the spatial intensity profile.

5. The position measurement system of any of the preceding claims, wherein the identified disturbances and/or errors include at least one of: mechanical vibrations, thermal variations, modal noise, polarization variations or wavefront misalignments along the optical path.

6. The position measurement system of any of the preceding claims, wherein a lens system is arranged between the multimode optical fiber output and the one or more detectors.

7. The position measurement system of any of the preceding claims, wherein the interferometer system comprises a heterodyne interferometer.

8. The position measurement system of any of the preceding claims, wherein the plurality of pixels comprises at least two pixels and up to at least three times the number of speckles of the spatial intensity profile.

9. The position measurement system of any of the preceding claims, wherein the plurality of pixels is arranged in a linear or two-dimensional detector array.

10. The position measurement system of claim 9, wherein the processing unit is configured to initiate the mathematical analysis from a central pixel located at or near the center of the detector array, and to perform the mathematical analysis with one or more pixels located radially outward from the central pixel.

11. The position measurement system of any of the preceding claims, wherein the mathematical analysis is selected from differential analysis, integral analysis, moment analysis, Fourier analysis, or combinations thereof.

12. An exposure apparatus comprising a position measurement system according to any of the preceding claims 1-11.

13. A projection system for an exposure apparatus, comprising a position measurement system according to any of the preceding claims 1-11.

14. A method for measuring a position along an optical path, the method comprising the steps of:
- measuring the position along the optical path to obtain a position measurement,
- outputting a position measurement signal representative of the position measurement,
- providing the position measurement signal to a multimode optical fiber,
- outputting by the multimode optical fiber a spatial intensity profile based on the position measurement signal,
- detecting the spatial intensity profile by one or more detectors comprising a plurality of pixels, each pixel being configured to detect a distinct spatial region of the spatial intensity profile,
- analysing each distinct spatial region by performing a mathematical analysis between a plurality of distinct spatial regions to determine one or more properties related to mode dispersion of the position measurement signal, and
- identifying disturbances and/or errors in the position measurement signal based on the one or more properties determined with the mathematical analysis.

15. The method of claim 14, further comprising the step of correcting the position measurement signal based on the identified disturbances and/or errors.
